# EUROPEAN PATENT APPLICATION

(11) **EP 4 529 385 A1**
(43) Date of publication of application: **26.03.2025**
(21) Application number: 23204929.6
(22) Date of filing: 20.10.2023
(51) Int. Cl.: H10B 43/40, H10N 97/00, H10B 43/27

(54) **CAPACITOR STRUCTURE**

(30) Priority: 21.09.2023 US 202318471292
(71) Applicant: MACRONIX INTERNATIONAL CO., LTD., Hsinchu (TW)
(72) Inventor: Yeh, Teng-Hao, Zhubei City, Hsinchu County 302 (TW); Lue, Hang-Ting, Hsinchu (TW); Hu, Chih-Wei, Toufen City, Miaoli County 351 (TW); Lee, Cheng-Yu, Taoyuan City 326022 (TW)
(74) Representative: Kurig, Thomas

(57) **Abstract**

Provided is a capacitor structure for a three-dimensional AND flash memory device. The capacitor includes a substrate having a capacitor array region and a capacitor staircase region, a circuit under array (CuA) structure disposed on the substrate, a bottom conductive layer disposed on the CuA structure, a stacked structure disposed on the bottom conductive layer, and pillar structures. The stacked structure includes dielectric layers and conductive layers alternately stacked. The conductive layers in the capacitor staircase region are arranged in a staircase form. The pillar structures are arranged in an array in the capacitor array region and penetrate through the stacked structure and the bottom conductive layer. A part of the conductive layers is electrically connected to a first common voltage source, and the rest of the conductive layers and the bottom conductive layer are electrically connected to a second common voltage source.

## Description

### BACKGROUND

### Technical Field

The present disclosure relates to a semiconductor structure, and in particular to a capacitor structure.

### Description of Related Art

For a three-dimensional AND memory device, as the array loading is increased, the demand for high capacity is accordingly increased. Generally speaking, the capacitance is proportional to the area, so the area occupied by the three-dimensional AND memory device is accordingly increased. Especially, in the case of a high-capacitance circuit, when capacitors are disposed in the periphery region in the periphery region of the array structure of the three-dimensional AND memory device, the chip area occupied by these capacitors is greatly increased.

### SUMMARY

The present disclosure provides a capacitor structure, in which a part of conductive layers of a stacked structure is electrically connected to a common voltage source, and the rest of the conductive layers of the stacked structure and the underlying bottom conductive layer are electrically connected to another common voltage source.

The capacitor structure of the present disclosure includes a substrate, a circuit under array (CuA) structure, a bottom conductive layer, a stacked structure and multiple pillar structures. The substrate has a capacitor array region and a capacitor staircase region. The circuit under array structure is disposed on the substrate. The bottom conductive layer is disposed on the circuit under array structure. The stacked structure is disposed on the bottom conductive layer, and includes a plurality of first dielectric layers and a plurality of conductive layers stacked alternately, wherein the conductive layers in the capacitor staircase region are arranged in a staircase form. The pillar structures are arranged in an array in the capacitor array region, and penetrate through the stacked structure and the bottom conductive layer. A part of the conductive layers is electrically connected to a first common voltage source, and the rest of the conductive layers and the bottom conductive layer are electrically connected to a second common voltage source.

In an embodiment of the capacitor structure of the present disclosure, the part of the conductive layers includes odd-numbered conductive layers of the plurality of conductive layers, and the rest of the plurality of conductive layers includes even-numbered conductive layers of the plurality of conductive layers.

In an embodiment of the capacitor structure of the present disclosure, at least a pair of adjacent conductive layers is electrically connected to the second common voltage source or the second common voltage source.

In an embodiment of the capacitor structure of the present disclosure, the bottom conductive layer and a lowermost conductive layer of the plurality of conductive layers are electrically connected to the second common voltage source or the second common voltage source.

In an embodiment of the capacitor structure of the present disclosure, one conductive layer connected to the first common voltage source, an adjacent conductive layer connected to the second common voltage source, and the first dielectric layer therebetween constitute a capacitance unit.

In an embodiment of the capacitor structure of the present disclosure, the capacitor structure further includes a plurality of conductive pillars, located in the capacitor staircase region, and disposed in the plurality of conductive layers and the bottom conductive layer, so that the plurality of conductive layers and the bottom conductive layer are electrically connected to the corresponding common voltage sources through the plurality of conductive pillars.

In an embodiment of the capacitor structure of the present disclosure, each of the plurality of pillar structures includes a first insulating pillar.

In an embodiment of the capacitor structure of the present disclosure, each of the plurality of pillar structures further includes a second insulating pillar disposed in the first insulating pillar.

In an embodiment of the capacitor structure of the present disclosure, each of the plurality of pillar structures further includes: a semiconductor layer, disposed between the first insulating pillar and the stacked structure and between the first insulating pillar and the bottom conductive layer; and an insulating layer, disposed between the semiconductor layer and the stacked structure and between the semiconductor layer and the bottom conductive layer.

In an embodiment of the capacitor structure of the present disclosure, each semiconductor layer is electrically connected to a third common voltage source through a conductive plug.

In an embodiment of the capacitor structure of the present disclosure, a conductive layer connected to the first common voltage source, a semiconductor layer, and the insulating layer therebetween constitute a capacitance unit.

In an embodiment of the capacitor structure of the present disclosure, a conductive layer connected to the second common voltage source, a semiconductor layer and the insulating layer therebetween constitute a capacitance unit.

In an embodiment of the capacitor structure of the present disclosure, the bottom conductive layer and the stacked structure have a first annular trench, the first annular trench penetrates through the bottom conductive layer and the stacked structure, and the first annular trench surrounds the stacked structure in the capacitor array region and the capacitor staircase region.

In an embodiment of the capacitor structure of the present disclosure, the bottom conductive layer and the stacked structure have a plurality of second annular trenches, each of the plurality of second annular trenches penetrates through the bottom conductive layer and the stacked structure, and each of the plurality of second annular trenches extends along a row direction of the capacitor array region and surrounds at least one row of the pillar structures and the stacked structure in the capacitor staircase region, so as to form an independent bottom conductive sector.

In an embodiment of the capacitor structure of the present disclosure, the capacitor structure further includes second dielectric layers disposed between adjacent conductive sectors, located between the first dielectric layers and corresponding to locations of the conductive layers in a stacking direction of the stacked structure.

Based on the above, in the capacitor structure of the present disclosure, a part of conductive layers of a stacked structure is electrically connected to a common voltage source, while the rest of the conductive layers of the stacked structure and the underlying bottom conductive layer are electrically connected to another common voltage source. In this manner, two conductive layers and a dielectric layer therebetween can constitute a capacitance unit, and the lowermost conductive layer of the stacked structure, the underlying bottom conductive layer and a dielectric layer therebetween can constitute a capacitance unit.

### BRIEF DESCRIPTION OF THE DRAWINGS

FIG. 1A is a schematic cross-sectional view of a capacitor structure of the first embodiment of the present disclosure.
FIG. 1B is a schematic top view of a capacitor structure of the first embodiment of the present disclosure.
FIG. 2 is a schematic perspective view of a metal oxide semiconductor capacitor contained in a circuit under array structure of an embodiment of the present disclosure.
FIG. 3 is a schematic cross-sectional view of a capacitor structure of the second embodiment of the present disclosure.
FIG. 4 is a schematic cross-sectional view of a capacitor structure of the third embodiment of the present disclosure.
FIG. 5A is a schematic top view of a capacitor structure of the fourth embodiment of the present disclosure.
FIG. 5B is a schematic cross-sectional view taken along the line B-B in FIG. 5A.
FIG. 6 is a perspective view of a stacked structure of the capacitor structure of the first embodiment.
FIG. 7A to FIG. 7E illustrate adjusting electrical connection relationships among conductive layers of a stacked structure, a bottom conductive layer, and common voltage sources to obtain the desired capacitance values.

### DESCRIPTION OF THE EMBODIMENTS

The embodiments are provided below and described in detail with the accompanying drawings, but the provided embodiments are not intended to limit the scopes contemplated by the present disclosure. In addition, the drawings are provided for illustration purposes only and are not drawn according to the original scale. In order to facilitate understanding, the same components are described with the same reference numerals in the following description.

The terms "including", "comprising", "having" and so on used in the text are all openended terms, which mean "including but not limited to".

Besides, the directional terms mentioned in the text, such as "on", "below" and so on, are only used to refer to the direction of the drawings, and are not used to limit the present disclosure. Thus, it should be understood that "on" and "below" can be used interchangeably and that when an element such as a layer or film is disposed "on" another element, the element may be disposed directly on another element, or there may be an intervening element disposed therebetween. On the other hand, when an element is described to be " disposed directly on" another element, there is no intervening element disposed therebetween.

The capacitor structure of present disclosure can be applied to and integrated with a three-dimensional AND flash memory device. Specifically, the capacitor structure of the present disclosure and the three-dimensional AND flash memory structure can be formed in the same process. The same stacked structure including alternately stacked multiple dielectric layers and multiple conductive layers can be used to form the capacitor structure of the present disclosure and the three-dimensional AND flash memory structure. In other words, the capacitor structure of the present disclosure can have a main scheme similar as that of the three-dimensional AND flash memory structure. Therefore, disposing additional capacitors in the periphery region of the array structure of the three-dimensional AND memory device is not required, so the chip area can be greatly saved. This will be described in detail below.

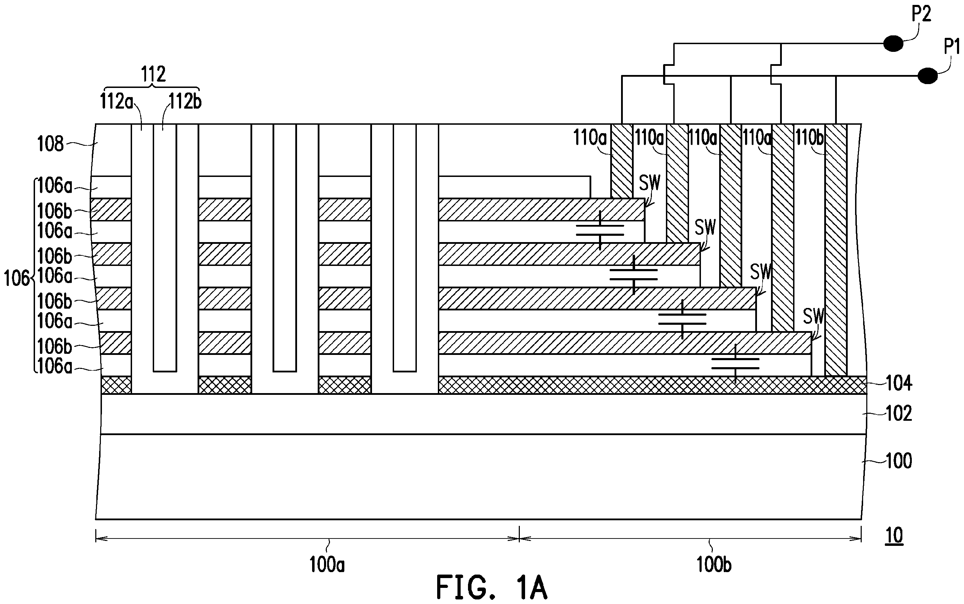

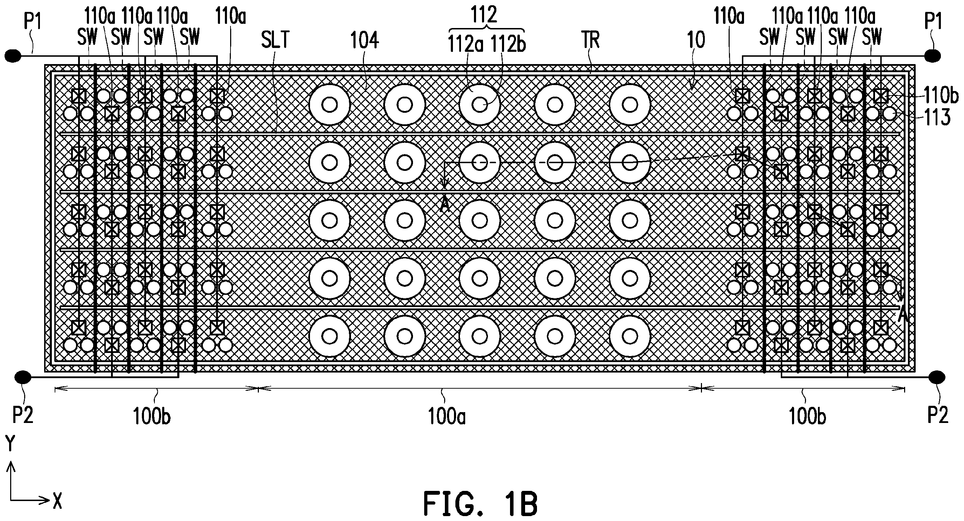

FIG. 1A is a schematic cross-sectional view of a capacitor structure of the first embodiment of the present disclosure. FIG. 1B is a schematic top view of a capacitor structure of the first embodiment of the present disclosure. For clarity of drawing and convenience of illustration, the stacked structure including alternately stacked multiple dielectric layers and multiple conductive layers is omitted from FIG. 1B. Besides, FIG. 1A may be a cross-sectional view taken along the line A-A in FIG. 1B.

Referring to FIG. 1A and FIG. 1B simultaneously, the capacitor structure 10 of this embodiment includes a substrate 100, a circuit under array structure 102, a bottom conductive layer 104, a stacked structure 106, a dielectric layer 108, conductive pillars 110a, a conductive pillar 110b and pillar structures 112. In this embodiment, the substrate 100 may be a silicon substrate, which has a capacitor array region 100a and a capacitor staircase region 100b. In addition, the substrate 100 may further have a memory region (not shown) other than the capacitor array region 100a and the capacitor staircase region 100b. The capacitor structure 10 of this embodiment and the three-dimensional AND flash memory structure can be formed in the same manufacturing process, so both of them have similar main schemes, and same or similar components in the capacitor array region 100a and the capacitor staircase region 100b are disposed in the above-mentioned memory region.

The circuit under array structure 102 is disposed on substrate 100. The circuit under array structure 102 may include a transistor, an interconnection structure, and a dielectric layer covering the transistor and the interconnection structure, but the present disclosure is not limited thereto. The detailed structure of the circuit under array structure 102 is well known to those skilled in the art, and is not be repeated herein. In FIG. 1A, the detailed scheme of the circuit under array structure 102 is not shown for clarity and convenience of illustration.

The bottom conductive layer 104 is disposed on the circuit under array structure 102. The bottom conductive layer 104 may be a polysilicon layer, but the present disclosure is not limited thereto. In this embodiment, the bottom conductive layer 104 located in the capacitor array region 100a and capacitor staircase region 100b may serve as an electrode layer of the capacitor (which will be described later), and the bottom conductive layer 104 located in the memory region of the substrate 100 may serve as a ground layer.

The stacked structure 106 is disposed on the bottom conductive layer 104. The stacked structure 106 includes a plurality of dielectric layers 106a and a plurality of conductive layers 106b stacked alternately. In this embodiment, the dielectric layers 106a may be silicon oxide layers, and the conductive layers 106b may be metal layers, but the present disclosure is not limited thereto. Besides, in this embodiment, the dielectric layers 106a and the conductive layers 106b are alternately stacked on the bottom conductive layer 104, the uppermost dielectric layer 106a covers the uppermost conductive layer 106b, and in the capacitor staircase region 100b, these conductive layers 106b are arranged in a staircase form. That is to say, in the capacitor staircase region 100b, the sidewall SW at the end of the upper conductive layer 106b is located on the top surface of the lower conductive layer 106b, so that a portion of the top surface of the lower conductive layer 106b is exposed. In addition, the uppermost dielectric layer 106a covers a portion of the uppermost conductive layer 106b, so that another portion of the top surface of the uppermost conductive layer 106b is exposed. In FIG. 1A, the stacked structure 106 includes five layers of dielectric layers 106a and four layers of conductive layers 106b, but the numbers of dielectric layers 106a and conductive layers 106b are not limited by the present disclosure.

The dielectric layer 108 covers the stacked structure 106. The conductive pillars 110a are disposed in the dielectric layer 108 in the capacitor staircase region 100b, and each of these conductive pillars 110a is connected to a corresponding one of the conductive layers 106b arranged in a staircase form. In addition, the conductive pillar 110b is disposed in the dielectric layer 108 in the capacitor staircase region 100b, and is connected to the bottom conductive layer 104. In this embodiment, as shown in FIG. 1B, from the top view, the conductive pillars 110a connected to a first group of the conductive layers 106b (e.g., odd-numbered conductive layers 106b) and the conductive pillars 110a connected to a second group of the conductive layers 106b (e.g., even-numbered conductive layers 106b) are in a staggered arrangement, and the conductive pillar 110b connected to the bottom conductive layer 104 and the adjacent conductive pillar 110a connected to the lowermost conductive layers 106b are in a staggered arrangement, but the present disclosure is not limited thereto.

In this embodiment, the capacitor structure 10 can have a main scheme similar to that of the three-dimensional AND flash memory structure located in the memory region of the substrate 100, and the difference between the two lies in that, in the capacitor structure 10, a part of the conductive layer 106b of the stacked structure 106 is electrically connected to a common voltage source through the conductive pillars 110a, while the rest of the conductive layer 106b of the stacked structure 106 and the bottom conductive layer 104 are electrically connected to another common voltage source through the conductive pillars 110a and the conductive pillar 1 10b. One of the two common voltage sources is a high voltage source, and the other of the two common voltage sources is a low voltage source.

Specifically, in this embodiment, from bottom to top, the bottom conductive layer 104 is electrically connected to the common voltage source P1 through the conductive pillar 110b, the second conductive layer and the fourth conductive layers 106b are electrically connected to the common voltage source P1 through the conductive pillars 11 0a, and the first conductive layer 106b and the third conductive layer 106b are electrically connected to the common voltage source P2 through the conductive pillars 110a, wherein the common voltage source P1 can be a low voltage source and the common voltage source P2 can be a high voltage source. In this way, the bottom conductive layer 104, the first conductive layer 106b, and the dielectric layer 106a between them can constitute a capacitance unit; the first conductive layer 106b, the second conductive layer 106b, and the dielectric layer 106b between them can constitute a capacitance unit; the second conductive layer 106b, the third conductive layer 106b, and the dielectric layer 106a between them can constitute a capacitance unit; and the third conductive layer 106b, the fourth conductive layer 106b, and the dielectric layer 106b between them can constitute a capacitance unit.

For the three-dimensional AND flash memory structure with a similar scheme, the conductive layers in the stacked structure are not connected to a common voltage source, so the conductive layers do not serve as electrodes of capacitors, and no capacitance is generated between adjacent conductive layers. That is to say, although the three-dimensional AND flash memory structure has a main scheme similar to that of the capacitor structure 10, their functions are completely different.

In addition, the pillar structures 112 are arranged in array in the capacitor array region 100a, and penetrate through the stacked structure 106 and the bottom conductive layer 104. In this embodiment, each pillar structure 112 includes an insulating pillar 112a and an insulating pillar 112b located in the insulating pillar 112a, but the present disclosure is not limited thereto. In other embodiments, each pillar structure 112 may only include the insulating pillar 112a. The material of the insulating pillar 112a is different than the material of the insulating pillar 112b. In one embodiment, the material of the insulating pillar 112a can be silicon oxide, and the material of the insulating pillar 112b can be silicon nitride, but the present disclosure is not limited thereto. In this embodiment, the pillar structures 112 are configured to support and stabilize the stacked structure 106 and are free of conductive function.

Besides, in this embodiment, multiple insulating support pillars 113 are disposed in the capacitor staircase region 100b and penetrate through the dielectric layer 108, the stacked structure 106 and the bottom conductive layer 104. The support pillars 113 may have the same or similar scheme as the c pillar structures 112. The width of the support pillars 113 may be less than the width of the pillar structures 112. The support pillars 113 may have the same height. In this embodiment, two support pillars 113 constitute a support pillar group, and are located beside the corresponding conductive pillar 110a or the conductive pillar 110b. From the top view, the conductive pillars 110a connected to the first group of the conductive layers 106b and the conductive pillars 110a connected to the second group of the conductive layers 106b are in a staggered arrangement, and the conductive pillar 110b connected to the bottom conductive layer 104 and the adjacent conductive pillar 110a connected to the lowermost conductive layers 106b are in a staggered arrangement, so these support pillar groups are also in a staggered arrangement in the capacitor staircase region 100b.

In this embodiment, as shown in FIG. 1B, the bottom conductive layer 104 and the stacked structure 106 have an annular trench TR. The annular trench TR penetrates through the bottom conductive layer 104 and the stacked structure 106 and surrounds the stacked structure 106 in the capacitor array region 100a and the capacitor staircase region 100b, so that the bottom conductive layer 104 in the capacitor structure 10 is electrically insulated from the bottom conductive layer 104 outside the annular trench TR (e.g., the bottom conductive layer 104 in the memory region). In this way, the capacitor structure 10 can be guaranteed to have a stable capacitance without external electrical influence. For example, parasitic capacitance can be avoided.

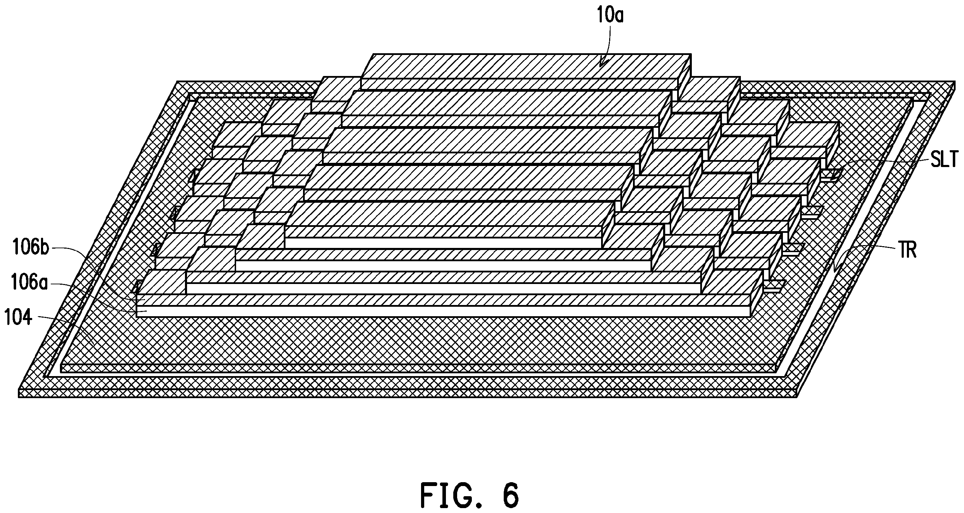

In addition, in this embodiment, as shown in FIG. 1B, the bottom conductive layer 104 and the stacked structure 106 have multiple lateral trenches SLT therein. In the capacitor array region 100a, each lateral trench SLT extends along a row direction (e.g., X direction), and is located between two adjacent rows of insulating pillars 112 in a column direction (e.g., Y direction). In this way, the stacked structure 106 can be divided into multiple blocks, and each block can be regarded as an independent sub-capacitor structure of the capacitor structure 10. For example, as shown in FIG. 6, the capacitor structure 10 may have four lateral trenches SLT, so the stacked structure 106 may be divided into five blocks; that is, the capacitor structure 10 includes five sub-capacitor structures 10a. In FIG. 6, only the dielectric layers 106a and the conductive layers 106b in the stacked structure 106 and the bottom conductive layer 104 are shown for clarity of drawing and convenience of illustration.

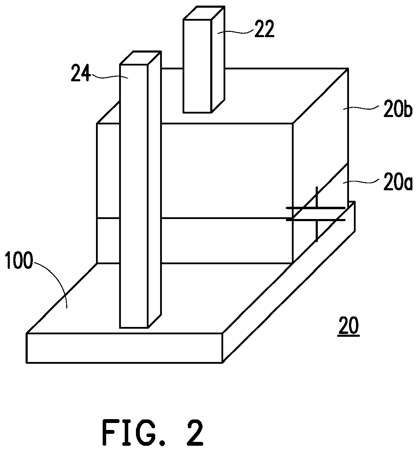

Besides, in order to further increase the capacitance value of the capacitor structure 10, in an embodiment, the circuit under array structure 102 may have multiple metal oxide semiconductor capacitors 20. As shown in FIG. 2, in metal oxide semiconductor capacitor 20, a gate dielectric layer 20a and a gate 20b are sequentially disposed on the substrate 100, a contact 22 is connected to the gate 20b, and a contact 24 is connected to the substrate 100. The substrate 100 may include a doped region. Each gate 20b is electrically connected to a common voltage source through the contact 22, and the substrate 100 is electrically connected to another voltage source through the contact 24. In this way, in each metal oxide semiconductor capacitor 20, the gate 20b, the substrate 100, and the gate dielectric layer 20a between them can constitute a capacitance unit.

In the capacitor structure 10 of this embodiment, in addition to the metal oxide semiconductor capacitors 20, multiple dielectric layers 106a and multiple conductive layers 106b alternately stacked on the bottom conductive layer 104 can form multiple capacitor units. Therefore, as compared with the 3D AND flash memory structure with a similar scheme, the capacitor structure 10 of this embodiment can have a larger capacitance. Moreover, in this embodiment, the number of capacitor units can be increased by increasing the number of stacked dielectric layers 106a and conductive layers 106b, so the capacitor structure of this embodiment can have a higher capacitance per unit area. In other words, a capacitor structure with a higher capacitance can be obtained without increasing the layout area.

Besides, for the capacitor structure 10, the electrical connection relationships among conductive layers 106b, the bottom conductive layer 104 and the common voltage sources P1 and P2 can be adjusted according to the actual requirements, so as to obtain the desired capacitance values. The details are described below.

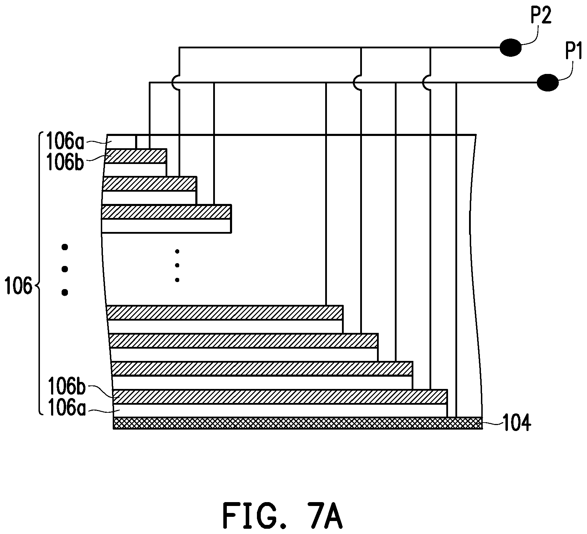

FIG. 7A to FIG. 7E illustrate adjusting electrical connection relationships among conductive layers of a stacked structure, a bottom conductive layer, and common voltage sources to obtain the desired capacitance values. In FIG. 7A to FIG. 7E, only the dielectric layers 106a, and the conductive layers 106b in the stacked structure, the bottom conductive layer 104 and the common voltage sources P1 and P2 are shown for clarity of drawings and convenience of illustration. In addition, in FIG. 7A to FIG. 7E, the elements that are the same as those in the first embodiment are denoted by the same reference numerals, so the details are not further described herein.

Referring to FIG. 7A, the stacked structure 106 includes 32 layers of conductive layers 106b. As described in FIG. 1A, the even-numbered conductive layers 106b and the bottom conductive layer 104 are electrically connected to a common voltage source P1, and the odd-numbered conductive layers 106b are electrically connected to a common voltage source P2. In this way, the capacitive structure 10 can have 32 groups of capacitive couplings with a total capacitance value C.

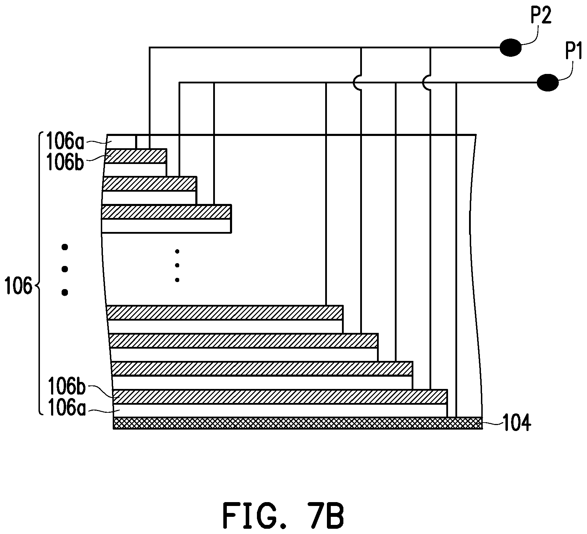

Referring to FIG. 7B, the 32^{nd} conductive layer 106b is adjusted to be connected to the common voltage source P2, and the 31^{st} conductive layer 106b is adjusted to be connected to the common voltage source P1, so that a capacitance unit cannot be formed between the 31^{st} conductive layer 106b and the 30^{th} conductive layer 106b. In this way, the capacitive structure 10 has 31 groups of capacitive couplings with a total capacitance of about 96.9% of C.

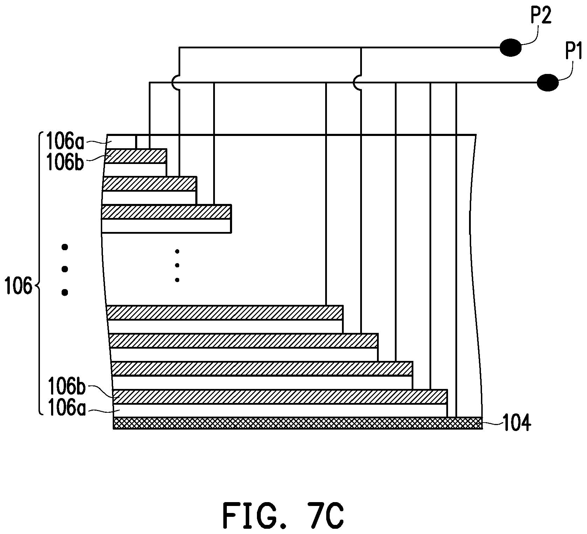

Referring to FIG. 7C, the 1^{st} conductive layer 106b is adjusted to be connected to the common voltage source P1, so that a capacitance unit cannot be formed between the 1^{st} conductive layer 106b and the 2^{nd} conductive layer 106b, and a capacitor unit cannot be formed between the 1^{st} conductive layer 106b and the bottom conductive layer 104. In this way, the capacitive structure 10 has 30 groups of capacitive couplings with a total capacitance of about 93.8% of C.

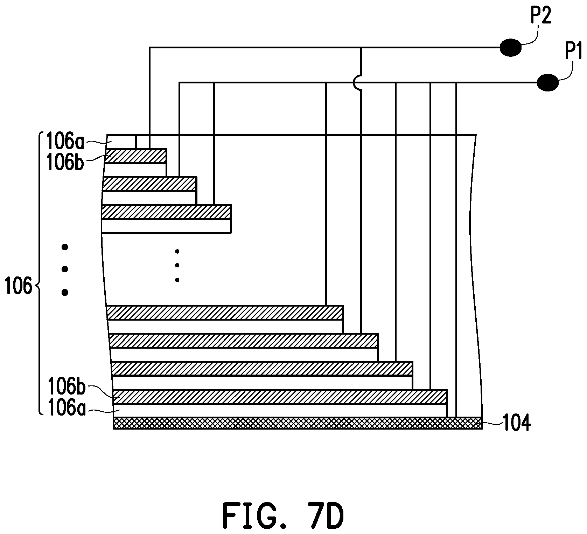

Referring to FIG. 7D, the 1^{st} conductive layer 106b is adjusted to be connected to the common voltage source P1, the 32^{nd} conductive layer 106b is adjusted to be connected to the common voltage source P2, and the 31^{st} conductive layer 106b is adjusted to be connected to the common voltage source P2, and thus, a capacitor unit cannot be formed between the 1^{st} conductive layer 106b and the 2^{nd} conductive layer 104, a capacitor unit cannot be formed between the 1^{st} conductive layer 106b and the bottom conductive layer 104, and a capacitor unit cannot be formed between the 31^{st} conductive layer 106b and the 30^{th} conductive layer 106b. In this way, the capacitive structure 10 has 29 groups of capacitive couplings with a total capacitance of about 90.6% of C.

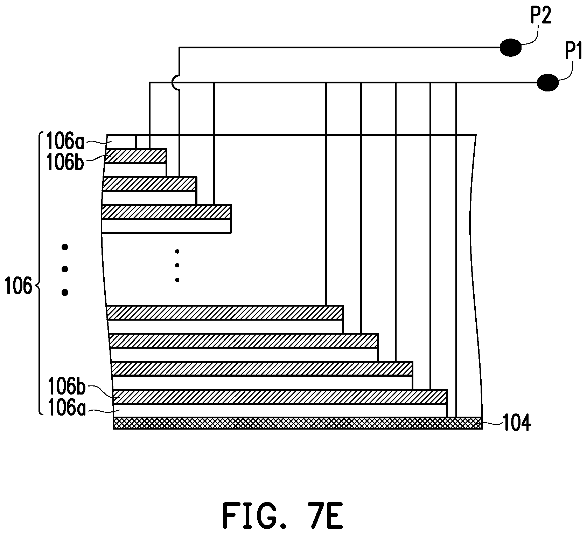

Referring to FIG. 7E, the 1^{st} conductive layer 106b and the 3^{rd} conductive layer 106b are adjusted to be connected to the common voltage source P1, so that a capacitor unit cannot be formed between the 1^{st} conductive layer 106b and the 2^{nd} conductive layer 106b, a capacitor unit cannot be formed between the 2^{nd} conductive layer 106b and the bottom conductive layer 104, a capacitor unit cannot be formed between the 2^{nd} conductive layer 106b and the 3^{rd} conductive layer 106b, and a capacitor unit cannot be formed between the 3^{rd} conductive layer 106b and the 4^{th} conductive layer 106b. In this way, the capacitive structure 10 has 28 groups of capacitive couplings with a total capacitance of about 87.5% of C.

In view of the above, the electrical connection relationships among conductive layers of the stacked structure, the bottom conductive layer and the common voltage sources can be simply adjusted, so as to obtain the desired capacitance values.

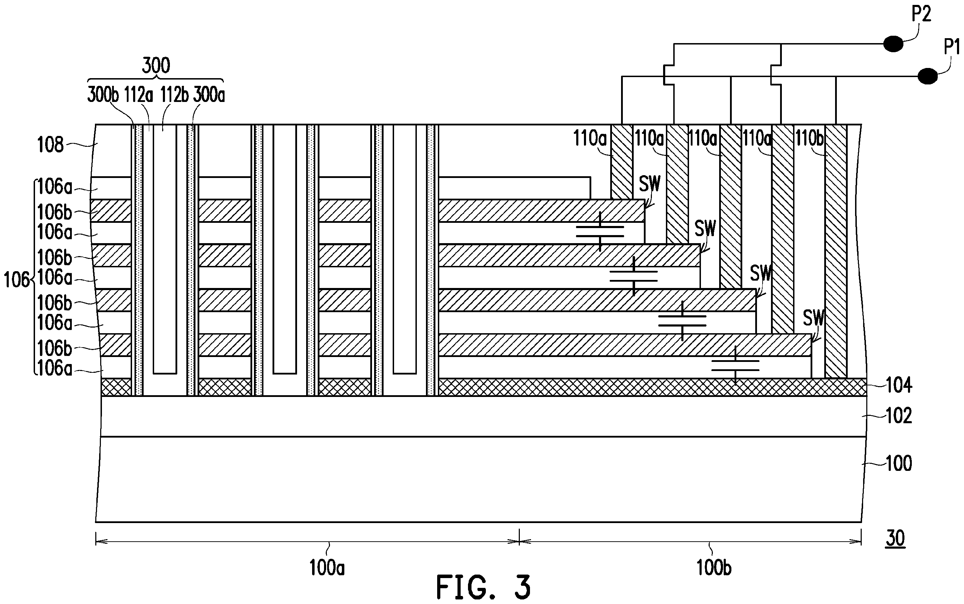

FIG. 3 is a schematic cross-sectional view of a capacitor structure of the second embodiment of the present disclosure. In FIG. 3, components identical to those of the first embodiment are labelled by the same reference numerals, so the details are not further described herein.

Referring to FIG. 3, the difference between the capacitor structure 30 of this embodiment and the capacitor structure 10 lies in that, in the capacitor structure 30, the pillar structures 112 are replaced by pillar structures 300. Specifically, in addition to the insulating pillar 112a and the insulating pillar 112b, each pillar structure 300 further includes a semiconductor layer 300a and an insulating layer 300b. The semiconductor layer 300a may include doped polysilicon. The semiconductor layer 300a is disposed between the insulating pillar 112a and the stacked structure 106 and between the insulating pillar 112a and the bottom conductive layer 104. The insulating layer 300b is disposed between the semiconductor layer 300a and the stacked structure 106 and between the semiconductor layer 300a and the bottom conductive layer 104. That is to say, the pillar structure 300 has a structure similar to that of the vertical channel pillar structure in the memory region, wherein the semiconductor layer 300a corresponds to the channel layer of the vertical channel pillar structure. However, unlike the vertical channel pillar structure, the pillar structure 300 of this embodiment is electrically floating, and is not electrically connected to other components through a conductive pillar.

In this embodiment, the bottom conductive layer 104 and the stacked structure 106 have an annular trench (e.g., the annular trench TR in FIG. 1B of the first embodiments) that penetrates through the bottom conductive layer 104 and the stacked structure 106, so that the bottom conductive layer 104 in the capacitor structure 30 is separated from and electrically insulated from the bottom conductive layer 104 in another region outside the annular trench.

In the first embodiment and the second embodiment described above, the pillar structures 112 and the pillar structures 300 in the capacitor array region 100a do not need to be electrically connected to an external voltage source; that is, an additional circuit layer to electrically connect the pillar structures 112 and the pillar structures 300 to an external voltage source is not required. In this way, the wirings in the capacitor array region 100a and the peripheral region (e.g., memory region) outside the capacitor staircase region 100b can extend through the capacitor array region 100a (the space above the pillar structures 112 and the pillar structures 300), so that the wiring layout design can have greater flexibility.

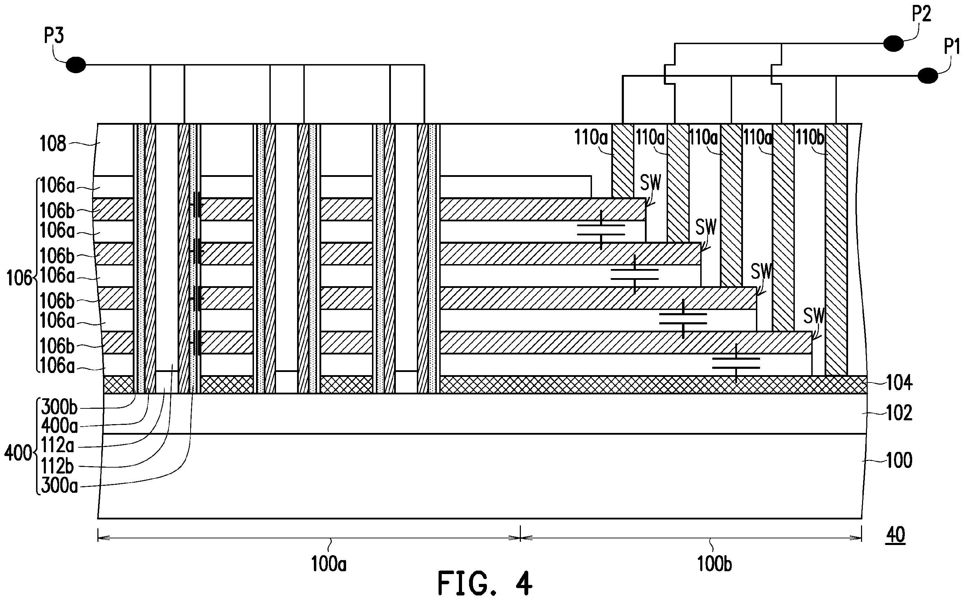

FIG. 4 is a schematic cross-sectional view of a capacitor structure of the third embodiment of the present disclosure. In FIG. 4, components identical to those of the second embodiment are denoted by the same reference numerals, so the details are not further described herein.

Referring to FIG. 4, the difference between the capacitor structure 40 of this embodiment and the capacitor structure 30 lies in that, in the capacitor structure 40, the pillar structures 300 are replaced by pillar structures 400. Specifically, in addition to the insulating pillar 112a, the insulating pillar 112b, the semiconductor layer 300a and the insulating layer 300b, each pillar structure 400 further includes two conductive plugs 400a. The conductive plugs 400a are disposed in the insulating pillar 112a and separated from each other through the insulating pillar 112b. In addition, the conductive plugs 400a are connected to the semiconductor layer 300a, so that the semiconductor layer 300a can be electrically connected to external components through the conductive plugs 400a. That is to say, the pillar structure 400 has a structure similar to that of the vertical channel pillar structure in the memory region, wherein the semiconductor layer 300a corresponds to the channel layer of the vertical channel pillar structure, and the conductive plugs 400a correspond to the source/drain pillars of the vertical channel pillar structure. However, unlike the vertical channel pillar structure, each semiconductor layer 300a in this embodiment is electrically connected to a common voltage source P3 through the two conductive plugs 400a.

Accordingly, in the capacitor structure 40, two adjacent conductive layers 106b and the dielectric layer 106a between them can constitute a capacitance unit; the lowermost conductive layer 106b, the bottom conductive layer 104 and the dielectric layer 106a between them can constitute a capacitance unit; and the conductive layer 106a, the semiconductor layer 300a, and the insulating layer 300b between them can constitute a capacitance unit.

In this embodiment, the bottom conductive layer 104 and the stacked structure 106 have an annular trench (e.g., the annular trench TR in FIG. 1B of the first embodiments) that penetrates through the bottom conductive layer 104 and the stacked structure 106, so that the bottom conductive layer 104 in the capacitor structure 40 is separated from and electrically insulated from the bottom conductive layer 104 in another region outside the annular trench.

In addition, in order to further accurately control the capacitance of the capacitor structure, the bottom conductive layer 104 located within the annular trench TR can be divided into multiple independent conductive sectors, so as to further avoid the generation of parasitic capacitance. The structure of the first embodiment (with the pillar structures 112) is taken as an example for illustration below, but the present invention is not limited thereto.

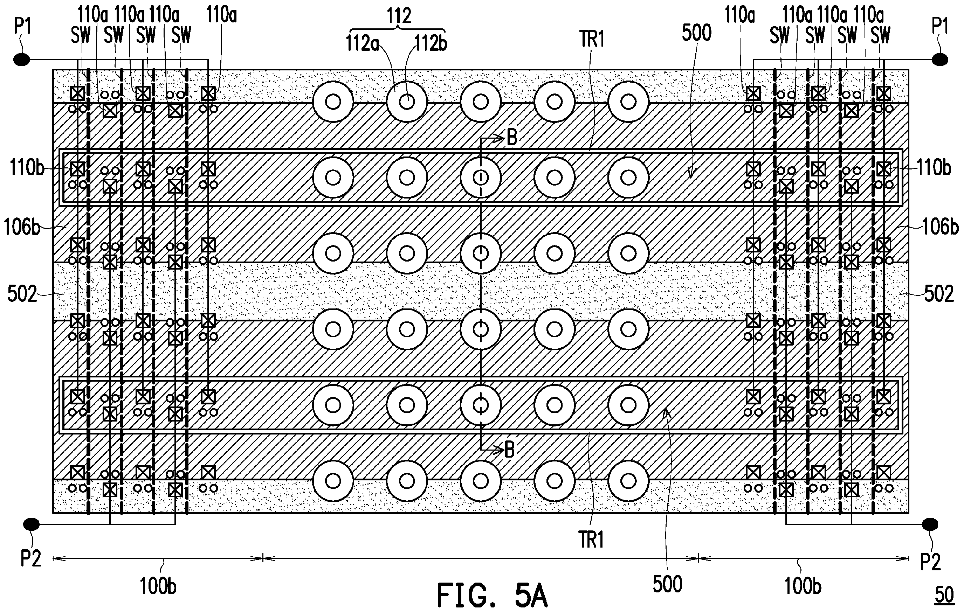

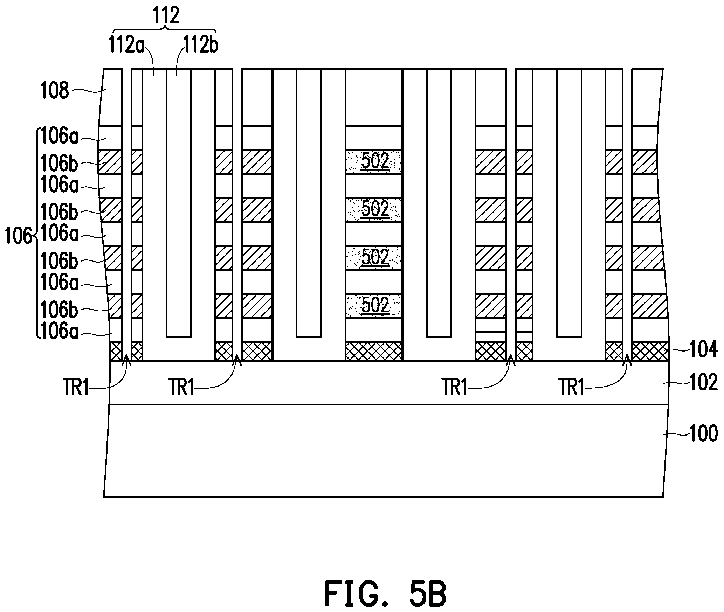

FIG. 5A is a schematic top view of a capacitor structure of the fourth embodiment of the present disclosure. FIG. 5B is a schematic cross-sectional view taken along the line A-A in FIG. 5A. In FIG. 5A and FIG. 5B, components identical to those of the first embodiment are labelled by the same reference numerals, so the details are not further described herein. In addition, in FIG. 5A, the dielectric layers 106a in the stacked structure 106 are omitted for clarity of drawing and convenience of illustration.

Referring to FIG. 5A and FIG. 5B simultaneously, the bottom conductive layer 104 and the stacked structure 106 have a plurality of annular trench TR1. Each annular trench TR1 penetrates through the bottom conductive layer 104 and the stacked structure 106, so as to divide the bottom conductive layer 104 and the stacked structure 106 into a plurality of independent conductive sectors 500. In this embodiment, each annular trench TR1 extends along the row direction of the capacitor array region 100a and surrounds at least one row of the pillar structures 112 and the stacked structure 106 in the capacitor staircase region 100b. Moreover, in this embodiment, in order to avoid interference (such as generating parasitic capacitance) between the adjacent conductive sectors 500, adjacent conductive sectors 500 are separated by a space including at least two rows of the pillar structures 112, but the present disclosure is not limited thereto.

Besides, in this embodiment, each conductive sector 500 surrounds one row of pillar structures 112, but the present disclosure is not limited thereto. In other embodiments, each conductive sector 500 can surround two rows, four rows, eight rows or more rows of the pillar structures 112 according to the actual requirements.

Moreover, in this embodiment, in a region between two adjacent conductive sectors 500, in the stacked structure 106, along a stacking direction, dielectric layers 502 are disposed between adjacent dielectric layers 106a and correspond to locations of the conductive layers 106b. Besides, the dielectric layers 502 are disposed between two rows of the conductive layers 106b. The material of the dielectric layers 502 is different from that of the dielectric layers 106a. In one embodiment, the dielectric layers 502 may silicon nitride layers, and the dielectric layers 106a may be silicon oxide layers, but the present disclosure is not limited thereto.

Specifically, the conductive layers 106b in the stacked structure 106 are formed by replacing the dielectric layer 502 in alternately stacked dielectric layers 106a and dielectric layers 502 with a conductive material. The above-mentioned replacing method includes, for example, using hot phosphoric acid to remove the dielectric layers 502 through the annular trenches TR1, and then filling a conductive material. In this embodiment, portions of the dielectric layers 502 adjacent to the annular trenches TR1 are removed, while other portions of the dielectric layers 502 remain. In this way, with the disposition of an annular trench TR1, a conductive sector 500 can be independently disposed, and can be isolated from another adjacent conductive sector 500 by a dielectric layer 502. In this way, there is an insulating structure including the dielectric layers 106a and the dielectric layers 502 between two adjacent conductive sectors 500, so that the capacitance of the capacitor structure in the two adjacent conductive sectors 500 can be more stable without being affected by mutual interference.

## Claims

1. A capacitor structure (10, 30, 40, 50), comprising:
a substrate (100), having a capacitor array region (100a) and a capacitor staircase region (100b);
a circuit under array structure (102), disposed on the substrate (100);
a bottom conductive layer (104), disposed on the circuit under array structure (102);
a stacked structure (106), disposed on the bottom conductive layer (104), and comprises a plurality of first dielectric layers (106a) and a plurality of conductive layers (106b) stacked alternately, wherein the plurality of conductive layers (106b) in the capacitor staircase region (100b) are arranged in a staircase form; and
a plurality of pillar structures (112, 300, 400), arranged in an array and penetrating through the stacked structure (106) and the bottom conductive layer (104) in the capacitor array region (100a),
wherein a part of the plurality of conductive layers (106b) is electrically connected to a first common voltage source (P2), and the rest of the plurality of conductive layers (106b) and the bottom conductive layer (104) are electrically connected to a second common voltage source (P1).

2. The capacitor structure according to claim 1, wherein the part of the conductive layers (106b) comprises odd-numbered conductive layers (106b) of the plurality of conductive layers (106b), and the rest of the plurality of conductive layers (106b) comprises even-numbered conductive layers (106b) of the plurality of conductive layers (106b).

3. The capacitor structure according to claim 1, wherein at least a pair of adjacent conductive layers (106b) is electrically connected to the first common voltage source (P2) or the second common voltage source (P1).

4. The capacitor structure according to claim 1, wherein the bottom conductive layer (104) and a lowermost conductive layer (106b) of the plurality of conductive layers (106b) are electrically connected to the first common voltage source (P2) or the second common voltage source (P1).

5. The capacitor structure according to claim 1, wherein one conductive layer (106b) connected to the first common voltage source (P2), an adjacent conductive layer (106b) connected to the second common voltage source (P1), and the first dielectric layer (106a) therebetween constitute a capacitance unit.

6. The capacitor structure according to claim 1, further comprising a plurality of conductive pillars (110a, 110b), located in the capacitor staircase region (100b), and disposed on the plurality of conductive layers (106b) and the bottom conductive layer (104), so that the plurality of conductive layers (106b) and the bottom conductive layer (104) are electrically connected to the corresponding common voltage sources (P1, P2) through the plurality of conductive pillars (110a, 110b).

7. The capacitor structure according to claim 1, wherein each of the plurality of pillar structures (112, 300, 400) comprises a first insulating pillar (112a).

8. The capacitor structure according to claim 7, wherein each of the plurality of pillar structures (112, 300, 400) further comprises a second insulating pillar (112b) disposed in the first insulating pillar (112a).

9. The capacitor structure according to claim 7, wherein each of the plurality of pillar structures (400) further comprises:
a semiconductor layer (300a), disposed between the first insulating pillar (112a) and the stacked structure (106) and between the first insulating pillar (112a) and the bottom conductive layer (104); and
an insulating layer (300b), disposed between the semiconductor layer (300a) and the stacked structure (106) and between the semiconductor layer (300a) and the bottom conductive layer (104).

10. The capacitor structure according to claim 9, wherein each semiconductor layer (300a) is electrically connected to a third common voltage source (P3) through a conductive plug (400a).

11. The capacitor structure according to claim 10, wherein a conductive layer (106b) connected to the first common voltage source (P2), a semiconductor layer (300a), and the insulating layer (300b) therebetween constitute a capacitance unit.

12. The capacitor structure according to claim 10, wherein a conductive layer (106b) connected to the second common voltage source (P1), a semiconductor layer (300a) and the insulating layer (300b) therebetween constitute a capacitance unit.

13. The capacitor structure according to claim 1, wherein the bottom conductive layer (104) and the stacked structure (106) have a first annular trench (TR1), the first annular trench (TR1) penetrates through the bottom conductive layer (104) and the stacked structure (106), and the first annular trench (TR1) surrounds the stacked structure (106) in the capacitor array region (100a) and the capacitor staircase region (100b).

14. The capacitor structure according to claim 1, wherein the bottom conductive layer (104) and the stacked structure (106) have a plurality of second annular trenches (TR1), each of the plurality of second annular trenches (TR1) penetrates through the bottom conductive layer (104) and the stacked structure (106), and each of the plurality of second annular trenches (TR1) extends along a row direction of the capacitor array region (100a) and surrounds at least one row of the pillar structures (112, 300) and the stacked structure (106) in the capacitor staircase region (100b), so as to form an independent conductive sector (500).

15. The capacitor structure according to claim 14, further comprising second dielectric layers (502) disposed between adjacent conductive sectors (500), located between the first dielectric layers (106a) and corresponding to locations of the conductive layers (106b) in a stacking direction of the stacked structure (106).

## Amended claims

### Amended claims in accordance with Rule 137(2) EPC.

1. A capacitor structure (10, 30, 40, 50), comprising:
a substrate (100), having a capacitor array region (100a) and a capacitor staircase region (100b);
a circuit under array structure (102), disposed on the substrate (100);
a bottom conductive layer (104), disposed on the circuit under array structure (102);
a stacked structure (106), disposed on the bottom conductive layer (104), and comprises a plurality of first dielectric layers (106a) and a plurality of conductive layers (106b) stacked alternately, wherein the plurality of conductive layers (106b) in the capacitor staircase region (100b) are arranged in a staircase form; and
a plurality of pillar structures (112, 300, 400), arranged in an array and penetrating through the stacked structure (106) and the bottom conductive layer (104) in the capacitor array region (100a),
wherein a part of the plurality of conductive layers (106b) is electrically connected to a first common voltage source (P2), and the rest of the plurality of conductive layers (106b) and the bottom conductive layer (104) are electrically connected to a second common voltage source (P1); the capacitor structure (10, 30, 40, 50) being **characterized in that**
the bottom conductive layer (104) and the stacked structure (106) have a plurality of second annular trenches (TR1), each of the plurality of second annular trenches (TR1) penetrates through the bottom conductive layer (104) and the stacked structure (106), and each of the plurality of second annular trenches (TR1) extends along a row direction of the capacitor array region (100a) and surrounds at least one row of the pillar structures (112, 300) and the stacked structure (106) in the capacitor staircase region (100b), so as to form an independent conductive sector (500).

2. The capacitor structure according to claim 1, wherein the part of the conductive layers (106b) comprises odd-numbered conductive layers (106b) of the plurality of conductive layers (106b), and the rest of the plurality of conductive layers (106b) comprises even-numbered conductive layers (106b) of the plurality of conductive layers (106b).

3. The capacitor structure according to claim 1, wherein at least a pair of adjacent conductive layers (106b) is electrically connected to the first common voltage source (P2) or the second common voltage source (P1).

4. The capacitor structure according to claim 1, wherein the bottom conductive layer (104) and a lowermost conductive layer (106b) of the plurality of conductive layers (106b) are electrically connected to the first common voltage source (P2) or the second common voltage source (P1).

5. The capacitor structure according to claim 1, wherein one conductive layer (106b) connected to the first common voltage source (P2), an adjacent conductive layer (106b) connected to the second common voltage source (P1), and the first dielectric layer (106a) therebetween constitute a capacitance unit.

6. The capacitor structure according to claim 1, further comprising a plurality of conductive pillars (1 10a, 1 10b), located in the capacitor staircase region (100b), and disposed on the plurality of conductive layers (106b) and the bottom conductive layer (104), so that the plurality of conductive layers (106b) and the bottom conductive layer (104) are electrically connected to the corresponding common voltage sources (P1, P2) through the plurality of conductive pillars (110a, 110b).

7. The capacitor structure according to claim 1, wherein each of the plurality of pillar structures (112, 300, 400) comprises a first insulating pillar (112a).

8. The capacitor structure according to claim 7, wherein each of the plurality of pillar structures (112, 300, 400) further comprises a second insulating pillar (112b) disposed in the first insulating pillar (112a).

9. The capacitor structure according to claim 7, wherein each of the plurality of pillar structures (400) further comprises:
a semiconductor layer (300a), disposed between the first insulating pillar (112a) and the stacked structure (106) and between the first insulating pillar (112a) and the bottom conductive layer (104); and
an insulating layer (300b), disposed between the semiconductor layer (300a) and the stacked structure (106) and between the semiconductor layer (300a) and the bottom conductive layer (104).

10. The capacitor structure according to claim 9, wherein each semiconductor layer (300a) is electrically connected to a third common voltage source (P3) through a conductive plug (400a).

11. The capacitor structure according to claim 10, wherein a conductive layer (106b) connected to the first common voltage source (P2), a semiconductor layer (300a), and the insulating layer (300b) therebetween constitute a capacitance unit.

12. The capacitor structure according to claim 10, wherein a conductive layer (106b) connected to the second common voltage source (P1), a semiconductor layer (300a) and the insulating layer (300b) therebetween constitute a capacitance unit.

13. The capacitor structure according to claim 1, wherein the bottom conductive layer (104) and the stacked structure (106) have a first annular trench (TR1), the first annular trench (TR1) penetrates through the bottom conductive layer (104) and the stacked structure (106), and the first annular trench (TRI) surrounds the stacked structure (106) in the capacitor array region (100a) and the capacitor staircase region (100b).

14. The capacitor structure according to claim 1, further comprising second dielectric layers (502) disposed between adjacent conductive sectors (500), located between the first dielectric layers (106a) and corresponding to locations of the conductive layers (106b) in a stacking direction of the stacked structure (106).
